Europäisches Patentamt

European Patent Office

Office européen des brevets

(19)

(11) Publication number: **0 307 484**

**A1**

# EUROPEAN PATENT APPLICATION

published in accordance with Art. 158(3) EPC

(21) Application number: **88902935.1**

(22) Date of filing: **30.03.88**

Data of the international application taken as a basis:

(86) International application number:
**PCT/JP88/00321**

(87) International publication number:
**WO88/07769 (06.10.88 88/22)**

(51) Int. Cl.³: **H 01 L 31/10**

(30) Priority: **31.03.87 JP 80548/87**

(43) Date of publication of application:
**22.03.89 Bulletin 89/12**

(84) Designated Contracting States:
**DE FR GB IT NL**

(71) Applicant: **KANEGAFUCHI KAGAKU KOGYO KABUSHIKI KAISHA**
**2-4 Nakanoshima 3-chome**
**Kita-ku Osaka-shi Osaka-fu(JP)**

(72) Inventor: **YAMAGISHI, Hideo**
**6-5-12, Maikodai 6-chome Tarumi-ku**
**Kobe-shi Hyogo 655(JP)**

(72) Inventor: **HIROE, Akihijo**
**6-9, Kugenumamatsugaoka 5-chome**
**Fujisawa-shi Kanagawa 251(JP)**

(54) **COLOR SENSOR.**

(57) A semiconductor color sensor comprising a semiconductor layer including a lamination of a plurality of pn or pin junctions, the semiconductor layer having an electrically conductive layer on both surfaces thereof. The color sensor is so constituted that the generation of photo-carriers should increase with the increasing distance from the junction of the input side in the whole wavelength range to be measured, and current is detected by changing the voltage between said two electrically conductive layers. The color sensor of the invention features its simplified structure, and it may easily be formed into an integrated circuit and formed with an increased effective area. In addition, the manufacturing process is simplified and the yield is increased, thus decreasing costs.

*FIG. 1*

./...

EP 0 307 484 A1

(72) Inventor: **NISHIO, Hitoshi**
**31-17, Shioya-cho 6-chome Tarumi-ku**
**Kobe-shi Hyogo 655(JP)**

(72) Inventor: **MURAKAMI, Satoru**
**6-5-22, Maikodai 6-chome Tarumi-ku**
**Kobe-shi Hyogo 655(JP)**

(72) Inventor: **MIKI, Keiko**
**9-6-301, Konan-cho 3-chome Higashinada-ku**
**Kobe-shi Hyogo 658(JP)**

(72) Inventor: **YAMAGUCHI, Minori**
**5-40, Higashihitomaru-cho**
**Akashi-shi Hyogo 673(JP)**

(72) Inventor: **MIZUKAMI, Seishiro**
**1-455-404, Nakaochiai 4-chome Suma-ku**
**Kobe-shi Hyogo 654(JP)**

(72) Inventor: **TAWADA, Yoshihisa**
**14-39, Oikemiyamadai Kita-ku**
**Kobe-shi Hyogo 651-11(JP)**

(74) Representative: **Türk, Gille, Hrabal**
**Bruckner Strasse 20**
**D-4000 Düsseldorf 13(DE)**

0307484

# DESCRIPTION

## COLOR SENSOR

### TECHNICAL FIELD

The present invention relates to a color sensor, and more particularly a color sensor wherein the construction of the sensor is simple, and it is easily integrated and large-scaled.

### BACKGROUND ART

Hitherto, color sensors are used in order to obtain information about spectra of incident light.

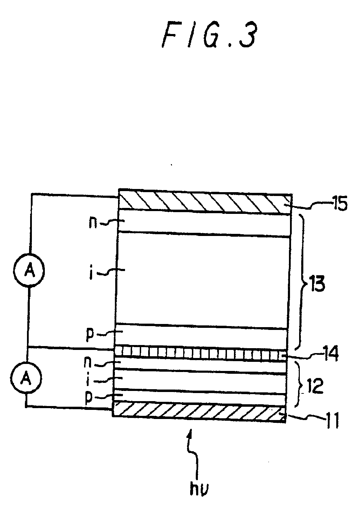

Among color sensors, color sensors using multi-junction semiconductors are considered to be favorable since they can detect each spectrum of the incident light without distribution by coloring filter and the like. The color sensor like this has generally a construction as shown in Fig. 3. Fig. 3 shows a two-stage pin junction as an example. In Fig. 3, numeral 11 is a transparent electrode such as TCO, numeral 12 is the first stage pin junction, and numeral 13 is the second stage pin junction. A transparent conductive film 14 is provided between the first stage pin junction 12 and the second pin junction 13. Numeral 15 is a back electrode provide the reversed side to the incident light.

In an element shown in Fig. 3, the short wave light (blue light) has weak penetration ability, so that it becomes mainly photoelectric current of the first stage pin junction, and the long wave light (red light) becomes photoelectric current of the first and the second stage pin junction. If the thickness of the first stage pin junction is made thin enough, red spectrum can be detected by detecting photoelectric current of the second stage.

However, it is necessary for the conventional color sensors comprising multi-junction semiconductors that three terminals are provided, and that a transparent conductive film is provided between both pin junctions. Therefore, if the number of stage is increased like three stages and four stages, it is necessary that four terminals and five terminals are provided respectively, and that two layers and three layers of transparent conductive films are provided respectively. Accordingly, the conventional color sensors have drawbacks that the constructions become complex when an integrated color sensor is made or they are used as linear sensors. Complication of construction, as a matter of course, brings complication of manufacturing process and increase of cost. And also, there is a problem that the yield of color sensors decreases because of short circuit being formed for a pin junction even if there are a few pinholes therein since electric potential of transparent films provided between every both pin junctions is considered to be almost equal.

Above-mentioned drawbacks taking into consideration, it is an object of the present invention to provide a color sensor wherein the construction of the sensor is simple, and it is easily integrated and large-scaled.

## DISCLOSURE OF THE INVENTION

A color sensor of the present invention is a semiconductor element comprising a semiconductor wherein a plurality of pn or pin junctions are laminated, and conductive layers which are laminated on both surfaces of the semiconductor, characterized in that the semiconductor element is arranged in a way that the quantity of production of photocarriers is increased in order from the light incident side for the whole wave length band to be measured, and that value of current is detected by changing voltage between both conductivity layers.

## BRIEF DESCRIPTION OF THE DRAWINGS
Fig. 1 is a schematic illustration of an embodiment of a color sensor of the present invention;

Fig. 2 is a graph showing characteristic curve of the color sensor shown in Fig. 1; and

Fig. 3 is a schematic illustration of the conventional color sensor comprising multi-junction semiconductor.

BEST MODE FOR CARRYING OUT THE INVENTION

Referring now to the drawings, there is explained a color sensor of the present ivnention.

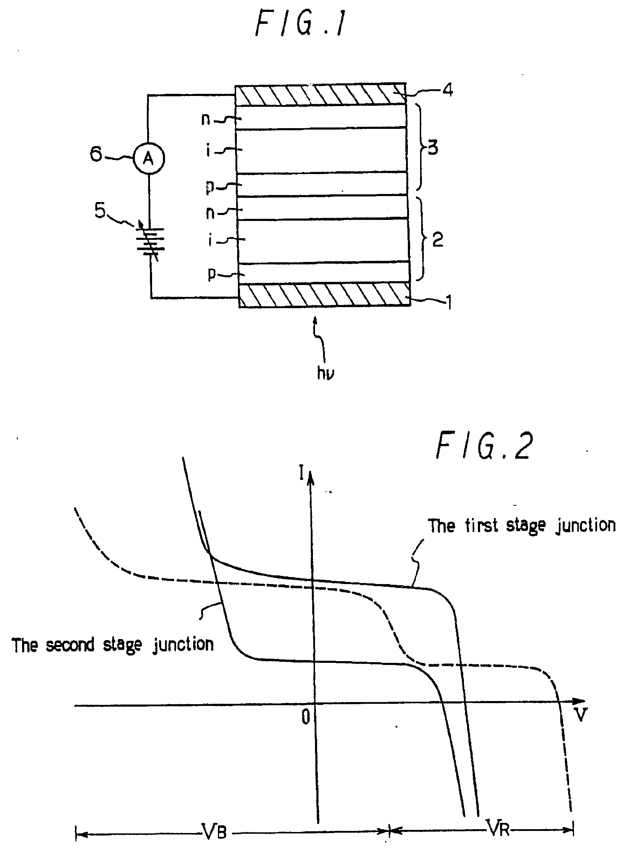

Fig. 1 is a schematic illustration of an embodiment of a color sensor of the present invention.

In Fig. 1, numeral 1 is a transparent electrode provided on the light incident side. Numeral 2 and 3 are the first stage pin junction and the second stage pin junction respectively, and they comprise a semiconductor layers wherein the layers are laminated in order of pin pin from the transparent electrode 1. A back electrode 4 is provided on n-type layer of the second stage of pin junction. Both the back electrode 4 and the transparent electrode 1 have conductivity, and terminals are formed therewith. After that, a circuit is formed with the back electrode 4, the transparent electrode 1, the terminals, a variable electric source 5 and an ammeter 6.

As a material of transparent electrode 1, oxide metal films such as ITO and $SnO_2$, thin metal films and films comprising the mixture thereof can be employed. As a material of back electrode, metals such as $A\ell$, Cu and Ag, which can make relatively ohmic contact with the neighbourhood semiconductor, are preferable, however, materials to be employed are not limited to them in the present invention.

As kinds of semiconductors comprising semiconductor layers, any of amorphous semiconductors, amorphous semiconductors containing crystallite, and crystal semiconductors can be employed. Among them it is preferable that amorphous semiconductors are employed because good characteristics semiconductors can be obtained by manufacturing process, which can form multi-junction in order with low cost, such as GD-CVD method and photo-CVD method.

As types of junction of semiconductor, either of pn junction and pin junction can be employed. There is no limitation to the thickness of p-type layer, i-type layer and n-type layer, however, the standard thickness of amorphous silicon, for example, is in the range of 100 Å to 500 Å, 100 Å to 700 Å and 100 Å to 500 Å respectively. And also, the semiconductor layers can be formed by sputtering method, MBF method and MOCVD method except the above-mentioned GD-CVD method and photo-CVD method. Further, a part of multi-junction is formed by normal ion implantation method. In addition the semiconductor layers are so constructed for value of photoelectric current generated by the semiconductor layer at the light incident side as to always be the most among values of photoelectric currents for the whole wave length band to be used. The construction like this can be realized by that the thickness of active layers, i.e. i-type layers of all pin junctions are made equal, since absorption coefficient of amorphous silicon in visible light band is larger for shorter wave length.

As amorphous semiconductors, alloys with elements such as C, N, Ge, Sn other than Si, i.e. a-SiC, a-SiN, a-SiSn, a-SiGe, a-SiCN and the like, and semiconductors containing crystalliters thereof.

Next, there is explained the features of the colar sensor shown in Fig. 1.

The fundamental feature is to detect the value of current with the ammeter 6 by applying voltage between the transparent electrode 1 and the back electrode 4.

Fig. 2 shows a characteristic curves of the element when the voltage is applied. In Fig. 2, the solid line shows a characteristic curve of each stage. The color sensor functionates so as for current in each stage to be equal as a whole element, so that the characteristic curve becomes as shown by dashed line. As shown in Fig. 2, there are two regions where the value of current is almost constant against voltage. And also, when a color sensor has four stages, there are four regions where the value of current is almost constant against voltage.

From Fig. 2, it is understandable that the value of current in the region of $V_R$ is almost equal to the value of Jsc of the second stage junction, so that the number of photo generating carriers can be estimated. And also, the number of photo generating carriers at first stage junction can be estimated in the region of $V_B$ similarly. Accordingly, if a color sensor is designed to absorb almost blue light at the first stage, only red light spectrum contributes to the value of current in the region of $V_R$, so that when light having only blue light spectrum, for example, is applied, the intensity of blue light can be estimated by amending the value of current in the region of $V_B$ with the value of current in the region of $V_R$.

Unless a semiconductor is so constructed for photoelectric current of light incident side as to be always larger than those of other regions in whole wave length band to be used beforehand, it is not determined which photoelectric current the values of current in the regions of $V_R$ and $V_B$ indicate. The regions of voltage such as $V_R$ and $V_B$ are determined by breakdown voltage. For amorphous semiconductors, the breakdown voltage is controlled with film thickness and film forming temperature.

## INDUSTRIAL APPLICABILITY

As is mentioned above, according to the color sensor of the present invention, the construction can be simplified, it is easily integrated and large-scaled, manufacturing process can be simplified, and the yiels of color sensors increases, so that there can be realized a color sensor with low cost.

CLAIM

1. A color sensor of semiconductor element comprising a semiconductor wherein a plurality of pn or pin junctions are laminated, and conductive layers which are laminated on both surfaces of the semiconductor, characterized in that the semiconductor element is arranged in a way that the quantity of production of photocarriers is increased in order from the light incident side for the whole wave length band to be measured, and that value of current is detected by changing voltage between both conductivity layers.

2. A color sensor according to Claim 1, characterized in that at least one of the junctions is pin junction comprising an amorphous semiconductor.

# FIG.1

# FIG.2

The first stage junction

The second stage junction

# FIG.3

# INTERNATIONAL SEARCH REPORT

International Application No  PCT/JP88/00321

## I. CLASSIFICATION OF SUBJECT MATTER (if several classification symbols apply, indicate all) [6]

According to International Patent Classification (IPC) or to both National Classification and IPC

$Int.Cl^4$    H01L31/10

## II. FIELDS SEARCHED

| Minimum Documentation Searched [7] | |
|---|---|
| Classification System | Classification Symbols |
| IPC | H01L31/04-31/10 |

| Documentation Searched other than Minimum Documentation to the Extent that such Documents are Included in the Fields Searched [8] | | |
|---|---|---|
| Jitsuyo Shinan Koho | 1962 | — 1988 |
| Kokai Jitsuyo Shinan Koho | 1971 | — 1988 |

## III. DOCUMENTS CONSIDERED TO BE RELEVANT [9]

| Category [*] | Citation of Document, [11] with indication, where appropriate, of the relevant passages [12] | Relevant to Claim No. [13] |
|---|---|---|
| Y | JP, A, 59-4183 (Fujitsu Ltd.) 10 January 1984 (10. 01. 84) Page 2, lower right column, lines 7 to 11 (Family: none) | 1, 2 |
| Y | JP, A, 55-125680 (Hamakawa Keimitsu) 27 September 1980 (27. 09. 80) & US, A, 4271328 | 1, 2 |
| A | JP, A, 61-115355 (Toshiba Corp.) 2 June 1986 (02. 06. 86) Figs. 2 to 3 (Family: none) | 1, 2 |
| A | JP, A, 61-77375 (Sharp Corporation) 19 April 1986 (19. 04. 86) | 1, 2 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search | Date of Mailing of this International Search Report |
|---|---|
| June 20, 1988 (20. 06. 88) | July 4, 1988 (04. 07. 88) |
| International Searching Authority | Signature of Authorized Officer |
| Japanese Patent Office | |

Form PCT/ISA/210 (second sheet) (January 1985)